Europäisches Patentamt

**European Patent Office**

**Office européen des brevets**

(19)

(11) Publication number: **0 166 964**
**A1**

(12) # EUROPEAN PATENT APPLICATION

(21) Application number: **85106583.9**

(22) Date of filing: **29.05.85**

(51) Int. Cl.⁴: **H 01 L 23/52**

(30) Priority: **04.06.84 US 617291**

(43) Date of publication of application:
**08.01.86 Bulletin 86/2**

(84) Designated Contracting States:
**DE FR GB**

(71) Applicant: **International Business Machines Corporation**
**Old Orchard Road**
**Armonk, N.Y. 10504(US)**

(72) Inventor: **Chappell, Barbara Alane**
**RED Adele Court Amawalk**
**Westchester New York 10501(US)**

(74) Representative: **Hobbs, Francis John**
**IBM United Kingdom Patent Operations Hursley Park**
**Winchester, Hants, SO21 2JN(GB)**

(54) A double level polysilicon semiconductor structure.

(57) In a double level polysilicon semiconductor structure, eg for a static RAM cell, a silicided outer region (42) of one portion (40) of the second level polysilicon layer serves as a conductive bus while an adjacent portion (34) serves as a resistor. The silicided outer region (42) is formed by depositing a silicide-forming metal on the one portion (40) of the second level polysilicon layer and annealing the structure. The second level polysilicon layer is undoped or only lightly doped.

FIG. 3

EP 0 166 964 A1

A DOUBLE LEVEL POLYSILICON SEMICONDUCTOR STRUCTURE

This invention relates to a double level polysilicon semiconductor structure in which a resistor and a conductive bus are formed in the second polysilicon level.

Static RAM cells of the type employing cross-coupled driver transistors, load devices connected between the transistors and a voltage supply bus, and coupling transistors having gates connected to a wordline and drains connected to bit lines are very well known.

Such structures are described in US-A-4,234,889 and US-A-4,246,593.

US-A-4,092,735 describes a similar RAM cell employing one transistor device and one load device.

Devices as described in the cited patent documents incorporate a double-level polysilicon integrated circuit structure with four interconnection levels: substrate, first poly level (poly1), second poly level (poly2) and metal level.

In US-A-4,234,889, the poly2 level is used for the voltage supply bus and the load devices. In US-A-4,246,593, the metal level is used for the voltage supply bus and poly2 is used for the load devices. In US-A-4,092,735, the metal level is used for the voltage supply bus and the load resistors are formed of an ion implant into the substrate.

EP-A2-48610 discloses a static RAM cell in which the resistor structures are formed in the poly2 level and a voltage bus is formed by a separately deposited layer of a silicide.

Typically, polysilicon load resistors such as for a static RAM NMOS cell are formed with undoped polysilicon and the power supply bus is formed with phosphorus doped polysilicon. Some of the potential problems with this process are autodoping of the undoped resistors by the phosphorus doped polysilicon which is a highly unpredictable phenomenon since it is a function of the poly grain structure. Perturbation of the underlying doped regions also occurs during the annealing of the doped poly2 bus, masking of the undoped resistor regions of the phosphorus deposition if a diffusion source is used, or penetration of the phosphorus implant if ion implantation is used.

The present invention seeks to provide an improved structure which avoids the problems associated with doped polysilicon bus structures.

A double level polysilicon semiconductor structure comprising a second level polysilicon layer separated from a first level polysilicon layer by an intermediate insulating layer and in which a first portion of the second level polysilicon layer serves as a resistor is characterised, according to the invention, by an outer region of a second portion of the second level polysilicon layer being silicided (ie converted to a silicide) in order to provide an electrically conductive bus.

The invention also provides a method of making a semiconductor structure as defined in the preceding paragraph, including masking the first portion of the second level polysilicon layer, depositing metal for forming a silicide with the unmasked polysilicon and heat treating the structure to provide the outer silicide region of the second portion of the second level polysilicon layer.

How the invention can be carried out will now be described by way of example, with reference to the accompanying drawings, in which:-

FIG. 1 is a schematic circuit diagram of a typical prior art RAM cell;

FIG. 2 is a perspective illustration of a portion of the physical structure forming a typical prior art double level RAM cell; and

FIG. 3 is a perspective illustration of the details of the physical structure forming a double level RAM cell according to the present invention.

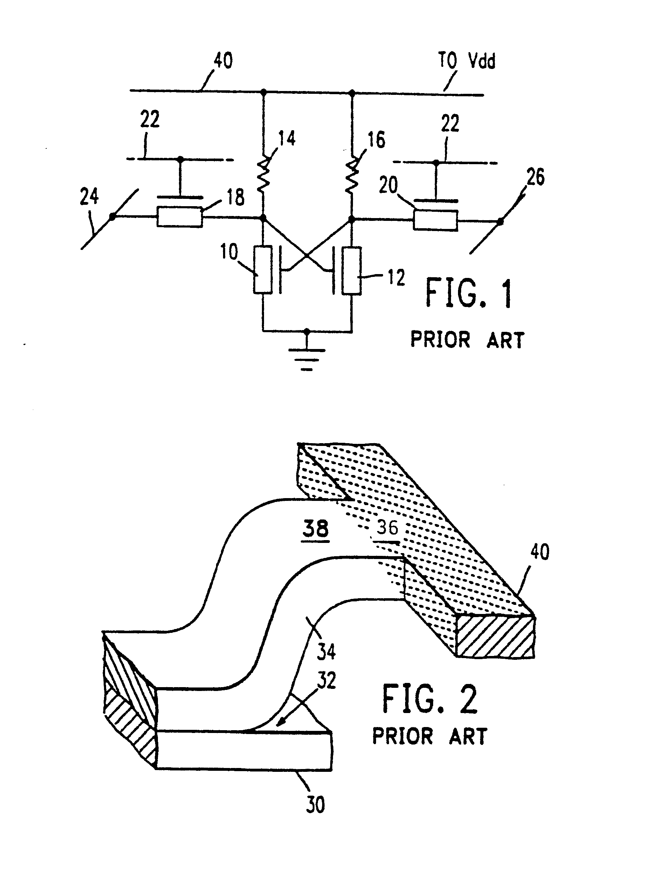

A typical known memory cell (FIG. 1) for a static RAM consists of a pair of cross-coupled driver transistors 10 and 12 having a common source connected to ground potential. Transistors 10 and 12 have drains which form storage nodes and are connected via a positive supply line to potential $V_{dd}$ through load resistors 14 and 16, respectively. Transistors 18 and 20 are coupling transistors through which the storage nodes are connected to bit lines 24 and 26, respectively. The gates of coupling transistors 18 and 20 are connected to wordlines 24 and 26, respectively.

The circuit shown in schematic form in FIG 1 is fabricated using integrated circuit techniques for forming the transistors on a silicon substrate. The structure is referred to as a double-level polysilicon structure. Such structure includes a first or lower layer of polysilicon material separated from a second or upper layer of polysilicon material by an intermediate dielectric layer. Areas of the first polysilicon layer may be doped to form transistor gates, address lines, interconnections, etc. Areas of the second polysilicon layer are used to form the load devices, that is, the resistors 14 and 16.

In FIG. 2, an illustration of a part of the integrated circuit of a typical RAM structure is shown including the first polysilicon layer 30, the undoped second polysilicon layer 34 and a poly1 to poly2 contact 32. The area 40 of poly2 represents the voltage bus to $V_{dd}$ and is separated and insulated from poly1 layer 30 by an intermediate oxide layer which is not shown in FIG. 2 in the interests of clarity. The poly2 region 40 which serves as a voltage bus is doped, for example with phosphorus, to be n+ as indicated by the dotted lines. The undoped poly2 region 38 is the load resistor 14 or 16 of FIG. 1. It should be noted in FIG. 2 that autodoping of the undoped resistor 38 by the phosphorus doped polysilicon 40 occurs because of indeterminate diffusion 36 along the grain boundaries of regions 38 and 40. Such autodoping or enhanced diffusivity is highly unpredictable since it is a function of the polysilicon grain structure. In addition, there may be perturbation of the underlying doped regions during the annealing of the doped poly2 region 40, or due to masking of the undoped resistor regions of the phosphorus deposition if a diffusion source is used, or penetration of the phosphorus implant may occur if ion implantation is used.

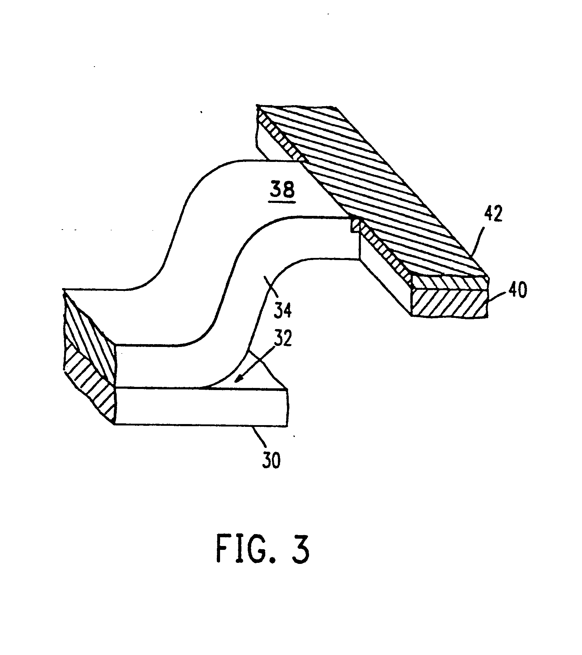

Referring to FIG. 3, a structure embodying the present invention is shown wherein undoped or lightly doped polysilicon 34 is used for the load resistor and a layer of silicided polysilicon 42 is used on poly2 layer 40 to form the voltage bus, the silicide layer 42 being the electrically conductive portion.

Use of this structure eliminates all of the previously mentioned problems found with doped polysilicon voltage supply bus structures. The resistance of the silicided polysilicon region 42 can be quite high by usual standards since the current is limited by the resistors to a very low value. Consequently relatively noncritical silicide processing procedures and low annealing temperatures can be used. If silicide is also used on the poly1 layer (as is typically the case in the present state of the art processes), then unintentional doping from the poly1 into the load R area will also be minimised.

Formation of the structure of FIG. 3 requires the same number (three) of masks or lithographic patterning steps as required for standard doped poly2 structures. One mask is required for the poly1 to poly2 contact hole, a second mask is used for resistor demarcation, and a third mask is needed for the poly2 layer patterning, but not necessarily in the listed order. For practising the present invention, the demands of the second level poly lithography are relatively noncritical, and this makes possible use of a variety of ways for forming the silicide patterning 42. For example, the silicide metal can be lifted-off the resistor regions 38 using known techniques. Alternatively the resistor regions 38 can be protected by an oxide layer before the silicide metal is deposited, and after reacting the silicide, the unreacted metal over the oxide regions can be etched away. Another alternative for forming the silicide layer 42 would be use of ion-beam reacted poly-silicide techniques. The ion-beam bombardment could be done before the poly2 region 40 was patterned in order to protect the underlying structures. An innocuous species could be used (such as silicon or argon) so that the tail of the implant would not be critical. Since very low resistance is not needed, ion-beam reaction without subsequent heat treatment could be used. If the metal is patterned before the ion-beam reacting step, the resistor 34 would see the bombardment which might result in more predictable grain structure and therefore more predictable resistor values. Alternatively, the resistor region 34 could be protected from the bombardment by photoresist and the unreacted metal etched away. As mentioned above, all of these techniques require the same number of extra masks (three) as required for the standard doped poly structures illustrated in FIG. 2.

More particularly, one example of a fabrication process that would result in a structure embodying the present invention is set forth in the following steps.

Step 1. Form single-crystal silicon and first-poly silicon structures as usual.

Step 2. Lay-down a passivation layer such as CVD $SiO_2$.

Step 3. Pattern a resist layer and etch the passivation layer so as to expose first-poly regions where first-poly to second-poly contacts are needed (such as on the first-poly which is attached to the drain nodes of devices 10 and 11 in FIG. 1).

Step 4. Lay-down the second-poly layer, undoped or lightly doped.

Step 5. Pattern the second-poly layer.

Step 6.   Deposit CVD $SiO_2$.

Step 7.   Pattern a resist layer and etch the CVD $SiO_2$ layer so that it remains over regions where second-poly load resistors are needed.

Step 8.   Deposit metal to be used for forming the silicide and heat treat with the minimum heat and time necessary to form a silicide (reaction step) (just the heat of the deposition process may be enough).

Step 9.   Etch away unreacted metal.

Step 10.  Complete fabrication of overlaying layers (passivation and metal layers) as usual.

One skilled in the art will realise that variations of the process just described are available for the fabrication of the structures embodying the present invention.

Thus, the present invention provides a resistor/voltage-bus structure utilising poly and polysilicide for use in supplying load current to a static MOS RAM cell.  Use of this structure offers several advantages in the physical design of the RAM cell and in the ease and control of the fabrication of the load resistors as compared with prior art structures.

Although the present invention has been described as being highly useful in the embodiment of a static RAM cell, one skilled in the art will appreciate that the invention is not limited to such use, but may be employed whenever a high value load and voltage bus structure is needed.

CLAIMS

1.    A double level polysilicon semiconductor structure comprising a second level polysilicon layer (34) separated from a first level polysilicon layer (30) by an intermediate insulating layer and in which a first portion (38) of the second level polysilicon layer serves as a resistor characterised by an outer region (42) of a second portion (40) of the second level polysilicon layer being silicided (ie converted to a silicide) in order to provide an electrically conductive bus.

2.    A semiconductor structure as claimed in claim 1, in which the first and second portions of the second level polysilicon layer are contiguous.

3.    A semiconductor structure as claimed in claim 1 or claim 2, in which the outer region (42) of the second portion (40) of the second level polysilicon layer is formed by masking the first (resistor, 38) portion of that layer, depositing metal for forming a silicide with the unmasked polysilicon and heat treating the structure to provide the outer silicide region (42) of the second portion (40) of the second level polysilicon layer.

4.    A semiconductor structure as claimed in any preceding claim, comprising a static RAM cell including a driver transistor, the first (resistor, 38) portion of the second level polysilicon layer being connected to an electrode of the driver transistor to serve as a load resistor and the second (conductive bus, 40) portion serving as a voltage bus.

5.    A method of making a semiconductor structure as claimed in claim 1 or claim 2, including masking the first (resistor, 38) portion of the second level polysilicon layer, depositing metal for forming a silicide with the unmasked polysilicon and heat treating the structure to provide the outer silicide region (42) of the second portion (40) of the second level polysilicon layer.

FIG. 1
PRIOR ART

FIG. 2
PRIOR ART

FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| Y | EP-A-0 097 595 (FAIRCHILD)<br>* Page 13, line 21 - page 14, line 12 * | 1 | H 01 L 23/52 |
| Y | GB-A-2 019 091 (SIEMENS)<br>* Page 2, lines 97-109 * | 1 | |
| A,D | EP-A-0 048 610 (TOKYO SHIBAURA)<br>* Page 12, steps 9-12 * | 1,4 | |
| A,D | US-A-4 234 889 (J.H. RAYMOND et al.)<br>* Column 2, line 63 - column 3, line 30 * | 1,4 | |
| | ----- | | **TECHNICAL FIELDS SEARCHED (Int Cl 4)**<br><br>H 01 L 23/52<br>H 01 L 27/10 |

The present search report has been drawn up for all claims

| Place of search<br>BERLIN | Date of completion of the search<br>28-08-1985 | Examiner<br>GIBBS C.S. |
|---|---|---|